# EUROPEAN PATENT APPLICATION

(11) **EP 2 586 538 A2**
(43) Date of publication of application: **01.05.2013**
(21) Application number: 11190919.8
(22) Date of filing: 28.11.2011
(51) Int. Cl.: B06B 1/06

(54) **Transducer module**

(30) Priority: 24.10.2011 TW 100138415
(71) Applicant: Chief Land Electronic Co. Ltd., Wugu Dist., New Taipei City 248 (TW)
(72) Inventor: Wang, Wen Chung, New Taipei City (TW); Chuang, Tsi-Yu, 52142 Changhua County (TW)
(74) Representative: Karakatsanis, Georgios

(57) **Abstract**

The present invention is directed to a transducer module, which includes at least two actuators with a same physical dimension. At least two support members correspond to the actuators, and are used to transfer inertial force to a vibration plate. Said two support members are disposed between neighboring actuators, and between the actuator and the vibration plate, respectively.

## Description

### BACKGROUND OF THE INVENTION

### 1. FIELD OF THE INVENTION

The present invention generally relates to an actuator, and more particularly to a stacked transducer module.

### 2. DESCRIPTION OF RELATED ART

An actuator is an energy conversion device that, for example, converts electrical energy to mechanical energy, and the converted mechanical energy further generates acoustic waves or haptic feedback. The actuator has been commonly used in a mobile electronic device or a human-machine interface device. In one trend of current applications, the actuator arranged in a device is demanded high inertial force output; in another trend, however, as the device has been miniaturized, the space available to accommodate the actuator is accordingly limited.

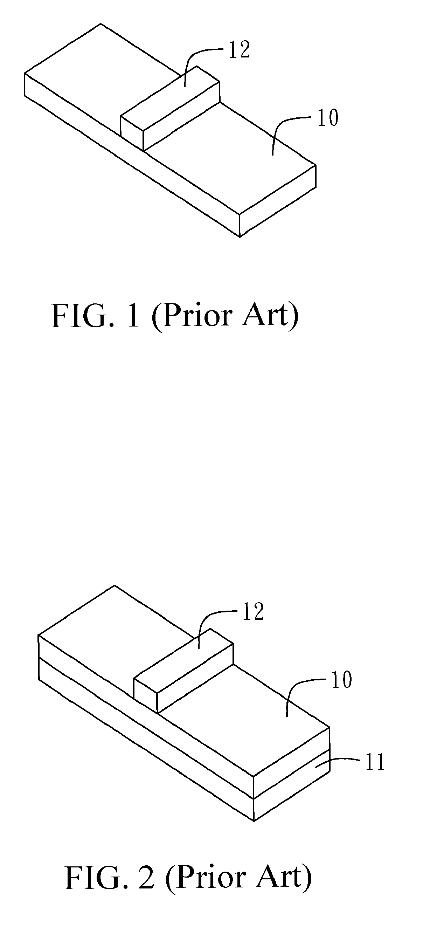

FIG. 1 shows a perspective view of a conventional transducer, which includes an actuator 10 and a support member 12. One end of the support member 12 is fixed on the surface of actuator 10, and the other end of the support member 12 is connected to a vibration plate (now shown). The conventional transducer as shown in FIG. 1 has a simple structure, but disadvantageously has little inertial force output, making its application ineffective.

FIG. 2 shows a perspective view of another conventional transducer, which includes plural actuators 10 and 11 that are directly stacked up. Although the transducer as shown in FIG. 2 improves the inertial force, however, the resonant mode of the original actuator is changed and its resonant frequency is uplifted. Accordingly, the arrangement needs overall adjustment, or the resonance in low frequency becomes worse, therefore reducing effective operation range.

FIG. 3 shows a perspective view of a further conventional transducer as disclosed in US Patent No. 7,684,576, entitled "Resonant Element Transducer," which includes plural actuators 10 and 11 having different dimensions with a support member 12 disposed between neighboring actuators.

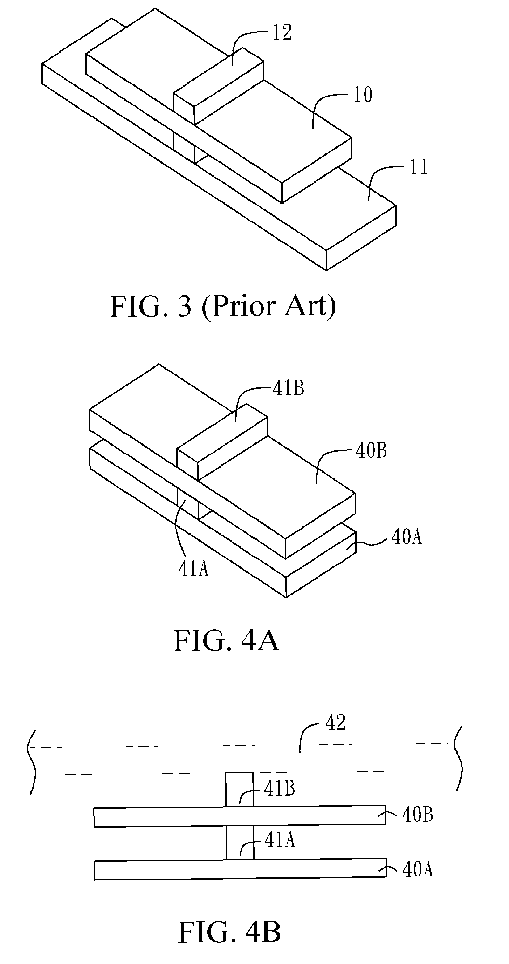

Each actuator 10/11 in FIG. 3 has its respective resonant mode. As a result, the resonant mode of the original actuator is changed. Moreover, it is difficult to make individual vibrations in phase to result in constructive interference, and therefore the increase in the inertial force is limited beyond a certain extent. Further, in practice, the vibrations of the actuators disturb each other, causing inconvenience in application and complexity in design.

For the foregoing reasons, a need has arisen to propose a novel transducer model that substantially increases inertial force and approaches a single resonant mode of the original actuator.

### SUMMARY OF THE INVENTION

In view of the foregoing, the embodiment of the present invention provides a transducer module constructed in a modular manner. The transducer module is capable of strengthening inertial force, and approaching a single resonant mode and effective operation range of an original actuator.

According to one embodiment, a transducer module includes at least two actuators and at least two support members, the actuators having a same physical dimension. The support members correspond to the actuators respectively, wherein the support members are used to transfer inertial force generated by the actuators to a vibration plate. Said at least two support members are disposed between the neighboring actuators, and between the actuator and the vibration plate. In one embodiment, the support member is disposed on each of opposite surfaces of the actuator.

### BRIEF DESCRIPTION OF THE DRAWINGS

FIG. 1 shows a perspective view of a conventional transducer;
FIG. 2 shows a perspective view of another conventional transducer;
FIG. 3 shows a perspective view of a further conventional transducer;
FIG. 4A and FIG. 4B show a perspective view and a cross-sectional view, respectively, of a transducer module according to a first embodiment of the present invention;
FIG. 5 shows exemplary comparison between resonant modes of the transducer module of the first embodiment (FIG. 4A/4B) and the conventional transducer of FIG. 1;
FIG. 6 shows exemplary comparison between resonant modes of the transducer module of the first embodiment (FIG. 4A/4B) and the conventional transducer of FIG. 2;
FIG. 7 shows exemplary comparison between resonant modes of the transducer module of the first embodiment (FIG. 4A/4B) and the conventional transducer of FIG. 3;
FIG. 8 shows a cross-sectional view of a transducer module according to an alternative embodiment of the first embodiment (FIG. 4A/4B);
FIG. 9A to FIG. 9B show cross-sectional views of transducer modules according to alternative embodiments of the first embodiment;
FIG. 10A and FIG. 10B show a perspective view and a cross-sectional view, respectively, of a transducer module according to a second embodiment of the present invention; and
FIG. 11 shows exemplary comparison between resonant modes of the transducer module of the second embodiment (FIG. 10A/10B) and the transducer module of the first embodiment (FIG. 4A/4B).

### DETAILED DESCRIPTION OF THE INVENTION

FIG. 4A and FIG. 4B show a perspective view and a cross-sectional view, respectively, of a transducer module according to a first embodiment of the present invention. In the embodiment, the transducer module includes at least two actuators, for example, a first actuator 40A and a second actuator 40B as shown in the figures. Each actuator 40A/40B corresponds with a support member 41A/41B such as a block. As exemplified in FIG. 4A and FIG. 4B, the first support member 41A is fixedly disposed between the first actuator 40A and the second actuator 40B, and a second support member 41B is fixedly disposed between the second actuator 40B and a vibration plate (such as a touch screen) 42. The support member 41A/41B is used to not only connect neighboring actuators (e.g., the first actuator 40A and the second actuator 40B) or connect the actuator and the vibration plate (e.g., the second actuator 40B and the vibration plate 42), but also transfer inertial force generated by the actuators 40A and 40B to the vibration plate 42.

In the embodiment, the inertial force generated by the second actuator 40B is transferred to the vibration plate 42 via the second support member 41B; the inertial force generated by the first actuator 40A is transferred to the vibration plate 42 via, in the order of, the first support member 41A, the second actuator 40B and the second support member 41B.

According to one aspect of the first embodiment of the present invention, the actuators 40A and 40B have a same physical dimension. As exemplified in FIG. 4A/4B, the first actuator 40A and the second actuator 40B have the same thickness, length and width. In the specification, the "same" physical dimension means that the dimensions of the actuators are the same in the manufacturing tolerance.

In addition to the same physical dimension, the actuators 40A and 40B are made of the same material or device such as piezoelectric material (e.g., lead-zirconate-titanate, PZT), electroactive polymer (EAP), shape memory alloy (SMA), magnetostrictive material, a voice coil motor or a linear resonant actuator (LRA).

Moreover, the actuators 40A and 40B are driven by the same control signal, therefore resulting in substantially the same resonant mode. Accordingly, the vibrations generated by the actuators 40A and 40B are substantially in-phase, therefore resulting in constructive interference and strengthening the transferred inertial force.

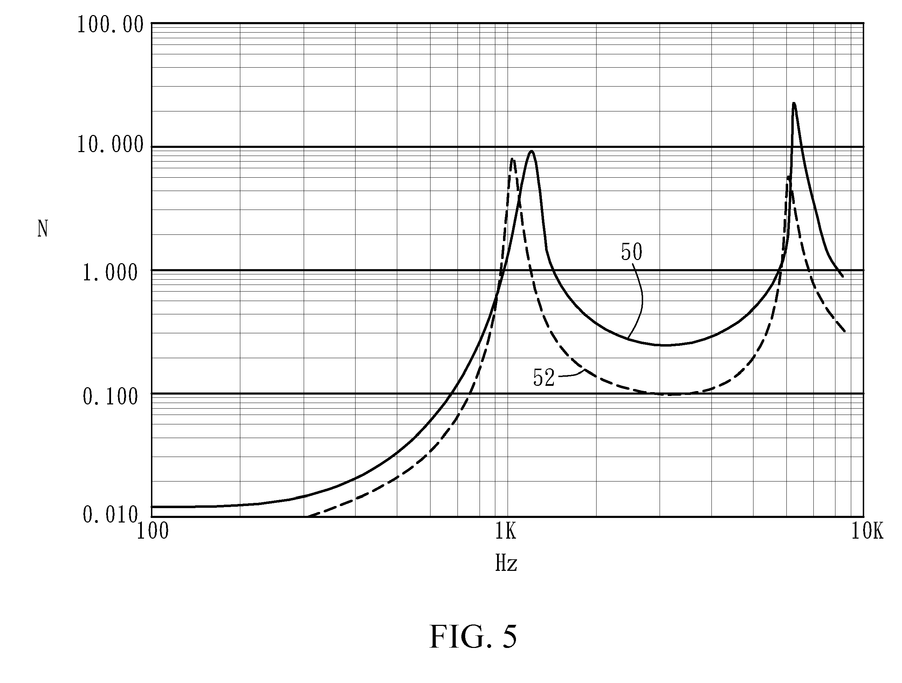

FIG. 5 shows exemplary comparison between resonant modes of the transducer module of the first embodiment (FIG. 4A/4B) and the conventional transducer of FIG. 1. The horizontal axis represents frequency (in Hz) and the vertical axis represents inertial force (in Newton or N). According to the figure, the frequency response curve 50 of the transducer module of the present embodiment is similar to the frequency response curve 52 of the conventional transducer, but has larger inertial force. In other words, the present embodiment approaches the resonant mode of the single original transducer with increased inertial force. If the number of the actuators is increased, a resonant mode of a single original transducer with more increased inertial force can be obtained. Therefore, the present embodiment provides a modular component, and a user may adaptively decide the amount of the actuators and associated support members according to required inertial force or available space in a mobile electronic device or a human-machine interface device without worrying about change in the resonant mode.

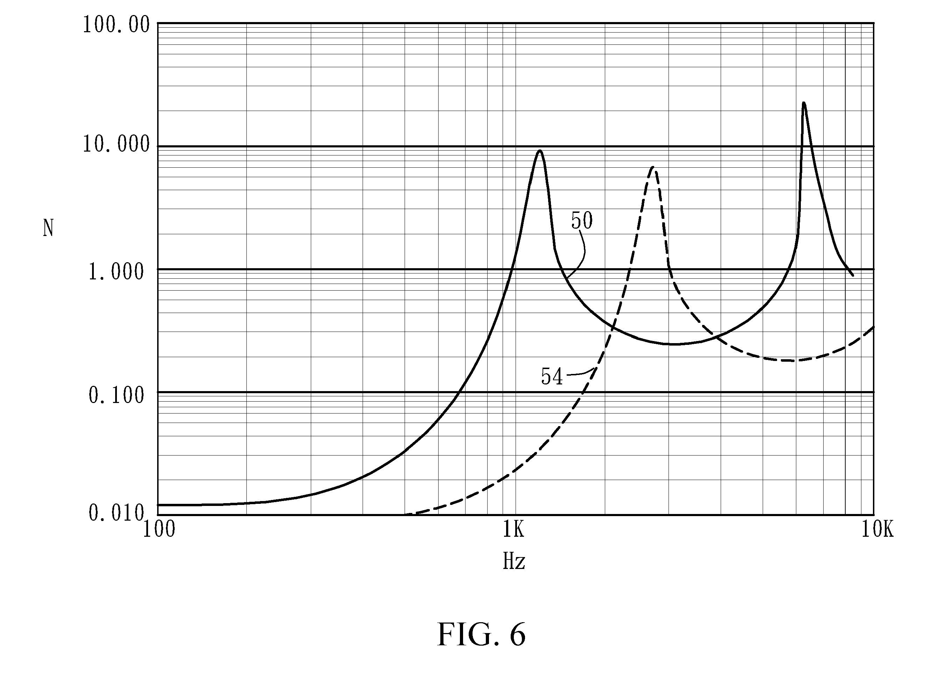

FIG. 6 shows exemplary comparison between resonant modes of the transducer module of the first embodiment (FIG. 4A/4B) and the conventional transducer of FIG. 2. As described above, the conventional transducer (FIG. 2) with actuators being directly stacked up changes the resonant mode of the original actuator such that the resonant frequency is up-lifted (as shown in the frequency response curve 54) and the arrangement needs overall adjustment; the resonance in low frequency becomes worse, therefore reducing effective operation range. To the contrary, according to the frequency response curve 50, the transducer module of the present embodiment approaches the resonant mode of the single original transducer with increased inertial force. In other words, the present embodiment has larger operation range and inertial force than the conventional transducer (FIG. 2) with actuators being directly stacked up.

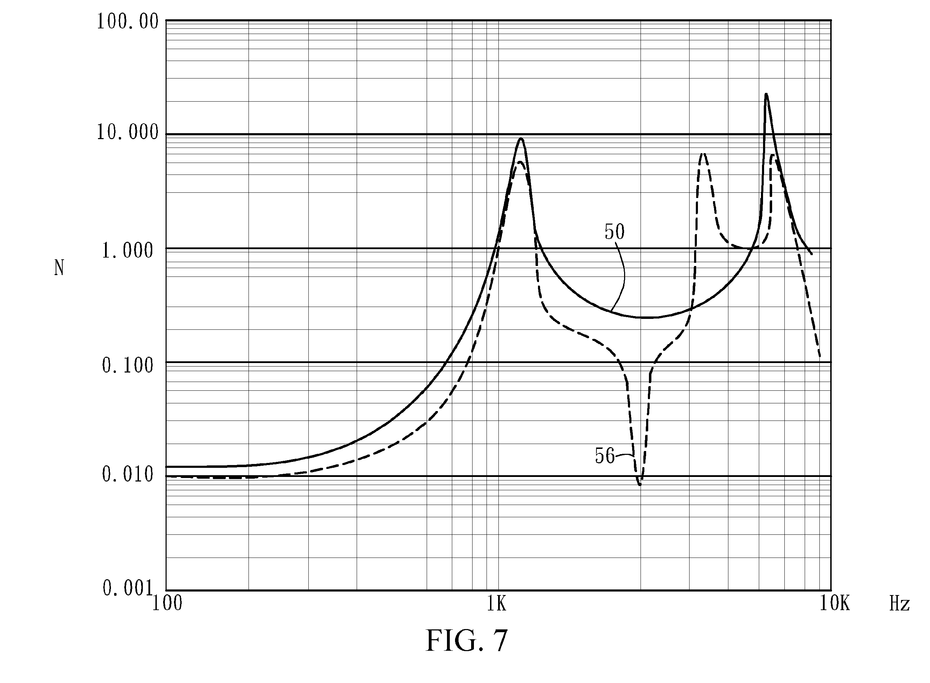

FIG. 7 shows exemplary comparison between resonant modes of the transducer module of the first embodiment (FIG. 4A/4B) and the conventional transducer of FIG. 3. As described above, the actuators of the transducer in FIG. 3 have different resonant modes, which disturb each other, thereby changing the resonant mode of the original actuator as shown in the frequency response curve 56. Due to different resonant modes, it is difficult to make individual vibrations in phase to result in constructive interference, and therefore the increase in the inertial force is limited beyond a certain extent. Further, in practice, the vibrations of the actuators disturb each other, causing complexity in design. To the contrary, according to the frequency response curve 50, the transducer module of the present embodiment approaches the resonant mode of the single original transducer with increased inertial force.

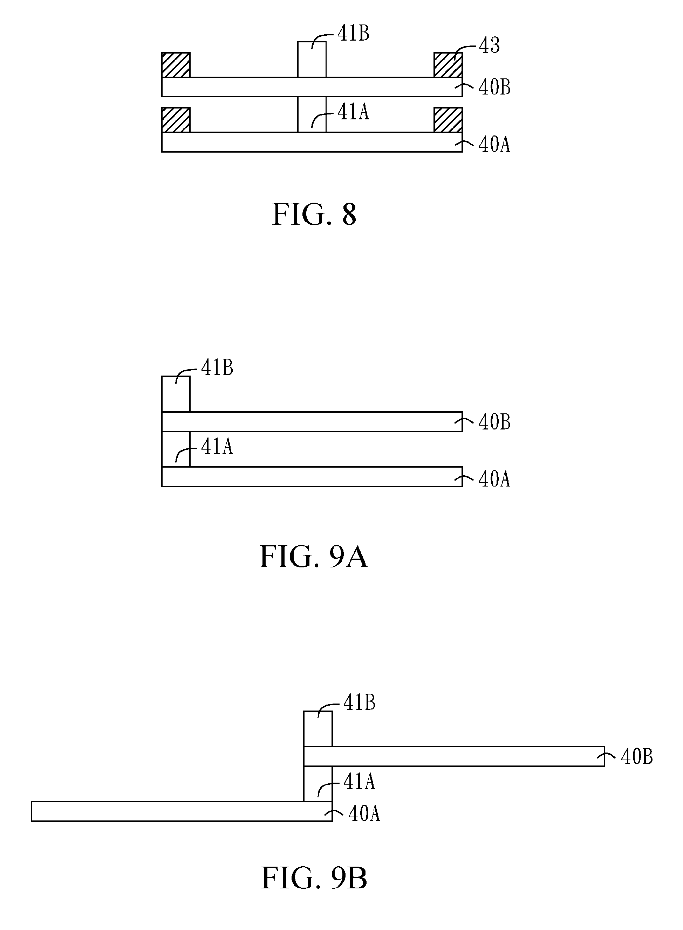

The actuator 40A/40B of the embodiment may include a unimorph actuator, a bimorph actuator, or a multimorph actuator. Moreover, as shown in FIG. 8, at least an inertial mass 43 may be disposed on the surface of the actuator 40A/40B in order to modify resonant frequency or strengthen vibration efficiency. It is noted that the shape of the actuator 40A/40B of the embodiment may be, for example, circular, rectangular or irregular shape, but not limited to the shown shape.

It is further noted that the support member 41A/41B may be disposed at a position other than that shown in FIG. 4A/4B, in which the support member 41A/41B is disposed at the middle of the actuator 40A/40B. For example, as shown in FIG. 9A and FIG. 9B, the support member 41A/41B may be disposed at a position other than the middle. As exemplified in FIG. 9A, the support members 41A and 41B are disposed at the same ends of the actuators 40A and 40B. As exemplified in FIG. 9B, the support members 41A and 41B are disposed at the opposite ends of the actuators 40A and 40B.

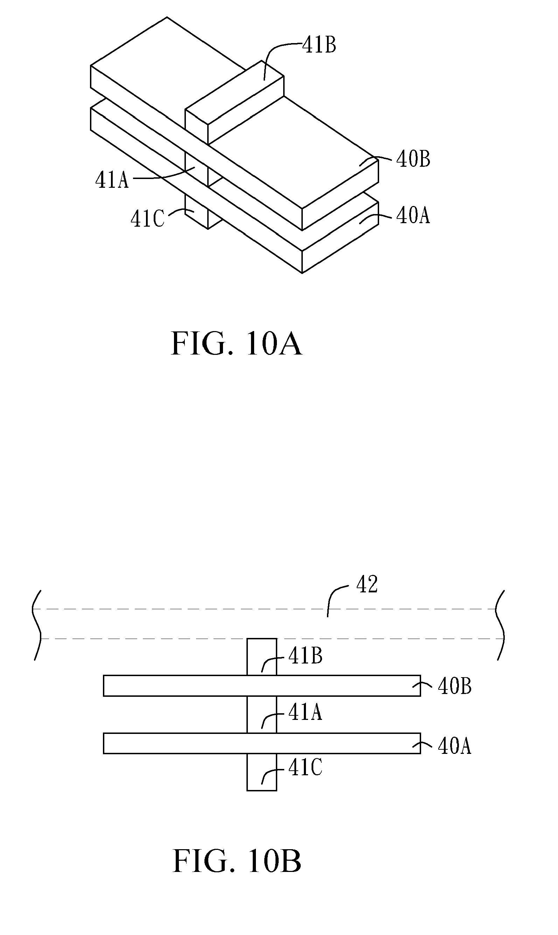

FIG. 10A and FIG. 10B show a perspective view and a cross-sectional view, respectively, of a transducer module according to a second embodiment of the present invention. Compared to the first embodiment shown in FIG. 4A/4B, the present embodiment further includes a third support member 41C, which is fixedly disposed on a surface (of the first actuator 40A) that is opposite to the surface on which the fist support member 41A is disposed. Compared to the first embodiment, the support member 41A/B/C is disposed on each of two opposite surfaces of each actuator 40A/40B of the present embodiment.

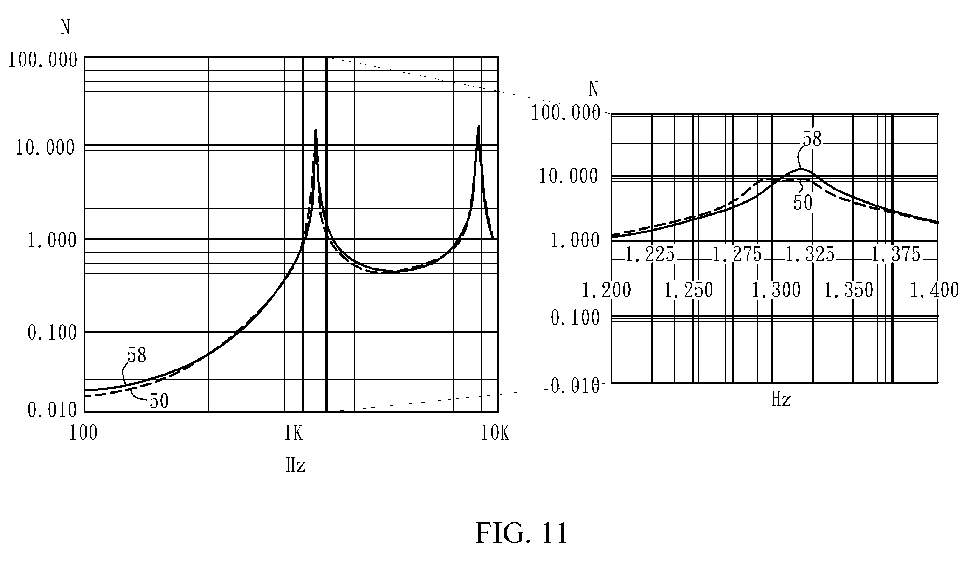

FIG. 11 shows exemplary comparison between resonant modes of the transducer module of the second embodiment (FIG. 10A/10B) and the transducer module of the first embodiment (FIG. 4A/4B). As the support member 41A/B/C is disposed on each of two opposite surfaces of each actuator 40A/40B, rendering the second embodiment more symmetric in structure than the first embodiment, and making the resonant modes of the actuators 40A and 40B more consistent. The arrangement of the support member 41C renders combination of the actuators 40A and 40B more complete, thereby resulting in a united peak in the curves. Moreover, the frequency response curve 58 of the second embodiment indicates larger inertial force than the frequency response curve 50 of the first embodiment as can be observed in an expanded curve portion in FIG. 11.

Although specific embodiments have been illustrated and described, it will be appreciated by those skilled in the art that various modifications may be made without departing from the scope of the present invention, which is intended to be limited solely by the appended claims.

## Claims

1. A transducer module, comprising:
at least two actuators with a same physical dimension; and
at least two support members corresponding to the actuators respectively, wherein the support members are used to transfer inertial force generated by the actuators to a vibration plate;
wherein said at least two support members are disposed between the neighboring actuators, and between the actuator and the vibration plate.

2. The transducer module of claim 1, wherein the actuators have a same material.

3. The transducer module of claim 2, wherein the actuator comprises piezoelectric material, electroactive polymer (EAP), shape memory alloy (SMA), magnetostrictive material, a voice coil motor or a linear resonant actuator (LRA).

4. The transducer module of claim 1, wherein the actuators are driven by a same control signal.

5. The transducer module of claim 4, wherein the actuators are driven in phase.

6. The transducer module of claim 1, wherein the actuator comprises a bimorph actuator.

7. The transducer module of claim 1, wherein the actuator comprises a unimorph actuator.

8. The transducer module of claim 1, wherein the actuator comprises a multimorph actuator.

9. The transducer module of claim 1, further comprising at least one inertial mass disposed on a surface of the actuator.

10. The transducer module of claim 1, wherein the support members are disposed at middle of the actuators.

11. The transducer module of claim 1, wherein the support members are disposed at ends of the actuators.

12. The transducer module of claim 1, wherein at least one said support member is disposed on each of opposite surfaces of the actuator.
